**Europäisches Patentamt**

**European Patent Office**

**Office européen des brevets**

(19)

(11) Veröffentlichungsnummer: **0 050 773**
**B1**

(12) ## EUROPÄISCHE PATENTSCHRIFT

(45) Veröffentlichungstag der Patentschrift:
24.09.86

(21) Anmeldenummer: 81108179.3

(22) Anmeldetag: 09.10.81

(51) Int. Cl.⁴: **H 01 L 29/60,** H 01 L 29/06,
H 01 L 29/78

(54) Steuerbares MIS-Bauelement.

(30) Priorität: 29.10.80 DE 3040775

(43) Veröffentlichungstag der Anmeldung:
05.05.82 Patentblatt 82/18

(45) Bekanntmachung des Hinweises auf die Patenterteilung:
24.09.86 Patentblatt 86/39

(84) Benannte Vertragsstaaten:
CH FR GB IT LI

(56) Entgegenhaltungen:
EP-A-0 037 115
DE-A-2 048 482
DE-A-2 950 413
DE-A-3 012 430
US-A-3 950 777

SIEMENS FORSCHUNGS- UND
ENTWICKLUNGSBERICHTE, Band 9, Nr. 4, 1980,
Berlin, München, J. TIHANYI "A qualitative study
of the DC performance of SIPMOS transistors"
IEEE Journal of solid-state circuits, vol. SC-11, no.
4, Aug. 1976, S. 472-477
(73) Patentinhaber: Siemens Aktiengesellschaft Berlin
und München, Wittelsbacherplatz 2, D-8000
München 2 (DE)

(72) Erfinder: Ladenhauf, Wilhelm, Ing.- grad.,
Adenauerstrasse 20, D-8031 Puchheim (DE)
Erfinder: Stengl, Jens- Peer, Ing.- grad.,
Gunterstrasse 13, D-8000 München 19 (DE)
Erfinder: Tihanyi, Jenö, Dr. Ing.,
Wolfratshauserstrasse 179b, D-8000 München 71
(DE)

## Description

Die Erfindung bezieht sich auf ein steuerbares MIS-Bauelement gemäß dem Oberbegriff des Anspruch 1. Ein solches MIS-Bauelement ist aus der US-A-3950 777 bekannt.

Ferner ist ein steuerbares MIS-Bauelement in Form eines Feldeffekttransistors (FET) zum Beispiel in IEEE Journal of Solid-State Circuits, Vol. SC-11, No. 4, Aug. 1976, s.472-477 beschrieben worden. Ein solcher Transistor hat, wie auch ein MIS-gesteuerter Thyristor oder ein MIS-gesteuerter Triac, eine Eingangskapazität, die das Schaltverhalten des Bauelements entscheidend bestimmt. Diese Eingangskapazität kann insbesondere bei höheren Frequenzen dazu führen, daß die Ausgangsspannung des Bauelements über die sogenannte Miller-Kapazität so stark auf den Steuereingang des Bauelements gegengekoppelt wird, daß das Bauelement nicht mehr voll aussteuerbar ist.

Der Erfindung liegt die Aufgabe zugrunde, die durch den größeren Abstand eines Teil der Gateelektrode verringerte Akkumulation von negativen Ladungsträgern an der Oberfläche der Drainzone zu kompensieren. Diese Aufgabe wird durch die Merkmale des kennzeichnenden Teils des Anspruchs 1 gelöst.

Weiterbildungen der Erfindung sind Gegenstand der Unteransprüche.

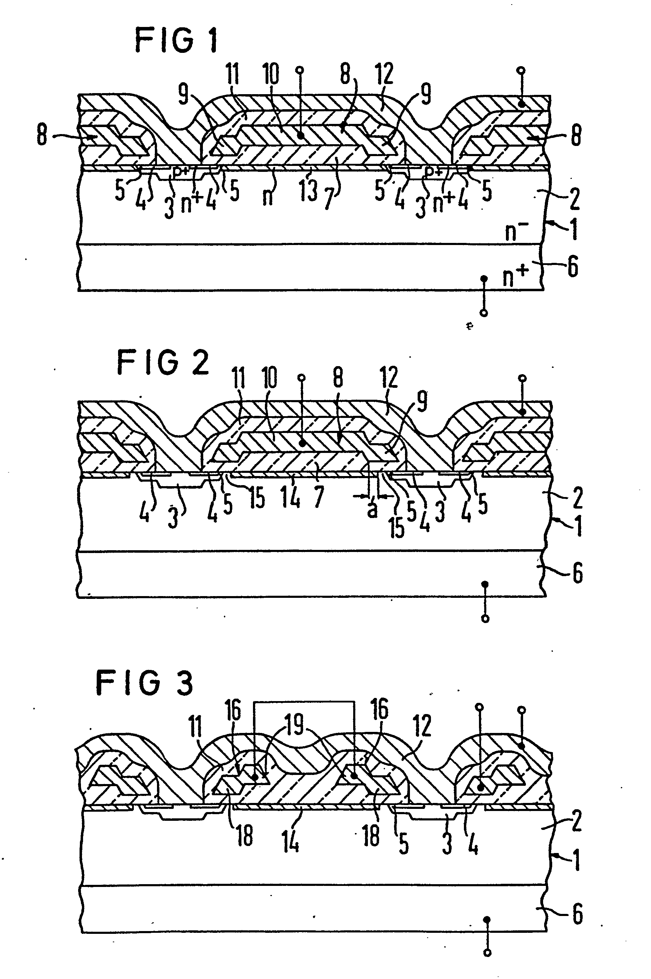

Die Erfindung wird an Hand einiger Ausführungsbeispiele in Verbindung mit den Fig. 1 bis 5 erläutert. In den Figuren sind Schnitte durch je einen Halbleiterkörper eines MIS-FET nach einem der fünf Ausführungsbeispiele dargestellt. Dabei sind gleiche oder funktionell gleiche Teile mit gleichen Bezugszeichen versehen.

Der Halbleiterkörper 1 nach Fig. 1 weist eine Zone 2 auf, die beispielsweise schwach n-dotiert ist. Sie bildet die Drain-Zone des MIS-FET. In die Drain-Zone 2 sind Zonen 3 des entgegengesetzten Leitfähigkeitstyps eingebettet. Sie sind beispielsweise stark p-dotiert. In die Zonen 3 wiederum sind Zonen 4 eingebettet, die gegenüber den Zonen 3 entgegengesetzten Leitfähigkeitstyp haben. Sie sind beispielsweise stark n-dotiert und dienen als Source-Zonen. Die Drain-Zone 2 erstreckt sich bis an die Oberfläche des Halbleiterkörpers 1. Die Zonen 3 bilden an der Oberfläche des Halbleiterkörpers Kanalzonen 5, die zwischen den Source-Zonen 4 und den an die Oberflächen des Halbleiterkörpers tretenden Teilen der allen Source Zonen gemeinsamen Drain-Zone 2 liegen. Die Oberfläche des Halbleiterkörpers ist mit einer Isolierschicht 7, zum Beispiel aus SiO$_2$ bedeckt, die im Bereich der Source-Zonen und der Zonen 3 Fenster für eine Kontaktierung offen läßt. Auf der Isolierschicht 7 sitzt eine Gate-Elektrode 8, die zum Beispiel aus stark n-dotierten Polysilicium besteht. Die Gate-Elektrode 8 ist von einer zweiten Isolierschicht 11, zum Beispiel ebenfalls aus SiO$_2$, bedeckt. Über dieser Isolierschicht liegt eine Metallschicht 12, die die Source-Zonen 4 und die Zonen 3 kontaktiert. Die ganze Anordnung ist auf einem Substrat 6 angeordnet, das beispielsweise stark n-dotiert ist.

Die Gate-Elektrode 8 hat zwei Bereiche 9 und 10, die unterschiedlichen Abstand zur Oberfläche des Halbleiterkörpers 1 einnehmen. Der erste Bereich 9 überdeckt die Kanalzonen 5, während der zweite Bereich 10 einen Teil der Drain-Zone 2 überdeckt. Der Abstand zwischen dem Bereich 10 und der Oberfläche des Halbleiterkörpers ist größer als der Abstand zwischen Bereich 9 und Oberfläche des Halbleiterkörpers. Der Bereich 9 überlappt außerdem einen Teil jeder Source-Zone 4 und einen Teil der an die Oberfläche des Halbleiterkörpers tretenden Drain-Zone 2.

Die Kapazität zwischen Gate-Elektrode 8 und der Drain-Zone 2 (entspricht etwa der Miller-Kapazität) kann auf diese Weise stark verringert werden. Der Abstand zwischen dem ersten Bereich 9 und der Kanalzone, der unter anderem die Einsatzspannung des MIS-FET bestimmt, kann demgegenüber gering gehalten werden. Der Abstand zwischen erstem Bereich und Oberfläche kann zum Beispiel zwischen 60 und 100 nm liegen, der Abstand zwischen zweitem Bereich und Oberfläche zwischen 200 und 300 nm. Da die Fläche der ersten Bereiche 9, die sich in erster Linie an der Fläche der Kanalzonen 5 ausrichtet, gegenüber der Fläche des Bereichs 10 klein gehalten werden kann, kann insgesamt eine deutliche Absenkung der Eingangskapazität erzielt werden.

Die größere Entfernung des Bereichs 10 von der Oberfläche des Halbleiterkörpers bringt es jedoch mit sich, daß an der Oberfläche des Halbleiterkörpers im eingeschalteten Zustand eine schwächere Akkumulation von negativen Ladungsträgern stattfindet. Um die Akkumulation von Ladungsträgern an der Oberfläche des Halbleiterkörpers zu verbessern, wird dort eine gegenüber der Drain-Zone höher dotierte Schicht 13 gleichen Leitungstyps angeordnet. Die Dotierung kann zum Beispiel eine Zehnerpotenz höher sein und zum Beispiel durch Ionenimplantation mit einer Dosis von 1 bis 3. 10$^{12}$ cm-2 Phosphor- oder Arsenionen hergestellt werden. Die Dicke der Schicht 13 kann in der Größenordnung 1 µm liegen. Im Ausfürungsbeispiel nach Fig. 1 stößt die Schicht 13 an die Kanalzonen 5 an.

In Fig. 2 ist ein anderes Ausführungsbeispiel dargestellt, bei dem in die Oberfläche der Drain-Zone 2 eine höher dotierte Schicht 14 eingebettet ist, die zwischen sich und den Kanalzonen 5 einen Zwischenraum 15 frei läßt. Dieser Zwischenraum kann zum Beispiel 1 bis 5 µm in lateraler Richtung betragen. In diesem Fall ist die Breite des ersten Bereichs 9 der Gate-Elektrode 8 so bemessen, daß sie sowohl die Kanalzone 5 als auch die Schicht 14 überlappt. Die Überlappung a beträgt zum Beispiel ebenfalls 1 bis 5 µm. Durch diese Anordnung wird die Akkumulation in der Schicht 14 durch ihre höhere Dotierung und im Zwischenraum 15 durch die geringe Entfernung des Bereichs 9 erzielt.

In Fig. 3 ist ein anderes Ausführungsbeispiel dargestellt, mit dem sich die Eingangskapazität weiter verringern läßt. Es unterscheidet sich von dem nach Fig. 2 dadurch, daß die Gate-Elektrode 16 in ihrem Bereich 19 eine Unterbrechung aufweist. Die Unterbrechung ist aber von der Metallschicht 12 überdeckt. Der Bereich 19 überdeckt teilweise die Drain-Zone 2 beziehungsweise die Schicht 14, während der Bereich 18 die Kanalzonen 5 überdeckt, die Source-Zonen 4 überlappt und einen Teil der Drain-Zone 2 beziehungsweise der Schicht 14 überdeckt. Hierbei ist der Bereich 18 als der obengenannte erste Bereich und der Bereich l9 als der obengenannte zweite Bereich anzusehen. Diese Form der Gate-Elektrode wirkt elektrisch etwa so, als ob der zweite Bereich 10 nach der Ausführungsform in Fig. 1 und 2 unendlich weit entfernt wäre. Die beiden Teile der Elektrode 16 sind elektrisch miteinander verbunden. Zwischen den Kanalzonen 5 und der Schicht 14 liegt hier wieder ein Abstand. Der Bereich 14 kann jedoch auch, wie in Verbindung mit Fig. 1 erläutert, an die Kanalzone 5 anstoßen.

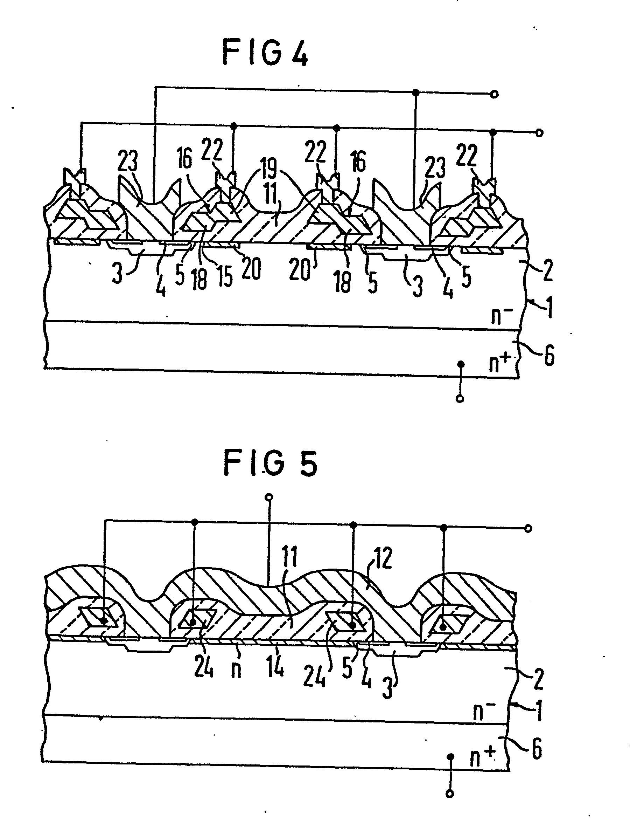

Das Ausführungsbeispiel nach Fig. 4 unterscheidet sich von dem nach Fig. 3 dadurch, daß die dort durchgehende Schicht 14 unterhalb der Unterbrechung der Gate-Elektrode 16 ebenfalls unterbrochen ist. Sie ist mit 20 bezeichnet. Zwischen der Schicht 20 und den Kanalzonen 5 kann wieder ein Zwischenraum 15 liegen oder die Schicht 20 kann entsprechend Fig. 1 an die Kanalzonen 5 anstoßen. In Fig. 4 ist noch dargestellt, daß die Gate-Elektroden 16 durch Kontakte 22 kontaktiert sind, die elektrisch miteinander verbunden sind. Ebenso sind die Source-Zonen 4 und die Zonen 3 über Kontakte 23 kontaktiert und miteinander elektrisch verbunden. Auch mit dieser Anordnung läßt sich gegenüber den Anordnungen nach Fig. 1 und 2 eine nochmals verringerte Eingangskapazität erzielen, während die Einsatzspannung durch die relativ geringe Entfernung des Bereichs 18 von den Kanalzonen 5 klein gehalten werden kann.

In Fig. 5 ist ein MIS-Halbleiterbauelement dargestellt, bei dem die Oate-Elektrode 24 über dem an die Oberfläche des Halbleiterkörpers tretenden Teil der Drainzone 2 eine Offnung aufweist. Die Gate-Elektrode hat hier den in den Ausführungsbeispielen nach Fig. 1 bis 4 verwendeten zweiten Bereich (10, 19) gewissermaßen vollständig eingebüßt und ist auf den die Kanalzonen 5 überdeckenden ersten Bereich reduziert. Dieser nimmt zur Oberfläche des Halbleiterkörpers einen relativ geringen Abstand von zum Beispiel 60 bis 100 nm ein. Die einzelnen Teile der Gate-Elektrode sind über Leitungen oder eine zusätzliche Metallisierung elektrisch miteinander verbunden. Die Schicht 14 kann auch hier durch die Schicht 20 ersetzt werden. Beide Schichten können an die Kanalzonen 5 anstoßen oder einen Zwischenraum freilassen.

Die Erfindung wurde an Hand eines MIS-FET beschrieben. Sie ist jedoch zum Beispiel auch für MIS-gesteuerte Thyristoren und Triacs anwendbar.

## Patentansprüche

1. Steuerbares MIS-Bauelement mit einem Halbleiterkörper (1), der eine Vielzahl elektrisch parallelgeschalteter Source-Zonen (4) aufweist, die in je einer Zone (3) entgegengesetzten Leitfähigkeitstyps eingebettet sind, mit an der Oberfläche des Halbleiterkörpers liegenden Kanalzonen (5), die Bestandteile der genannten Zonen (3) entgegengesetzten Leitfähigkeitstyps sind, mit einer allen Source-Zone (4) gemeinsamen Drain-Zone (2), die zwischen den gennanten Zonen (3) entgegengesetzten Leitfähigkeitstyps an die Oberfläche des Halbleiterkörpers (1) tritt, mit einer Gate-Elektrode (8, 16, 24), die durch eine Isolierschicht (7) gegen den Halbleiterkörper (1) isoliert ist und die die Kanalzonen (5), einen Teil jeder Source-Zone (4) und wenigstens einen Teil des an die Oberfläche des Halbleiterkörpers (1) tretenden Teils der Drain-Zone (2) überdeckt, und bei dem die Gate-Elektrode (8, 16, 24) zwei Bereiche (9, 10; 18, 19) aufweist, von denen der erste Bereich (9, 18), die Kanalzonen (5) überdeckt und einen ersten Abstand von der Oberfläche des Halbleiterkörpers (1) hat und von denen der zweite Bereich (10, 19) zwischen den Kanalzonen (5) liegt und einen zweiten, größeren Abstand von der Oberfläche des Halbleiterkörpers (1) hat, dadurch gekennzeichnet, daß in der Drain-Zone (2) an der Oberfläche des Halbleiterkörpers (1) eine Schicht (13, 14, 20) liegt, die den gleichen Leitungstyp, aber höhere Leitfähigkeit als die Drain-Zone (2) hat.

2. Steuerbares MIS-Bauelement nach Anspruch 1, dadurch gekennzeichnet, daß die Schicht (14, 20) an die Kanalzonen (5) anstößt.

3. Steuerbares MIS-Bauelement nach Anspruch 1, dadurch gekennzeichnet, daß zwischen der Schicht (14, 20) und den Kanalzonen (5) ein Zwischenraum (15) liegt, und daß der Zwischenraum vom ersten Bereich (9, 18) der Gate-Elektrode (8) überdeckt ist.

4. Steuerbares MIS-Bauelement nach Anspruch 3, dadurch gekennzeichnet, daß der erste Bereich (9, 18) die Schicht (14, 20) überlappt.

5. Steuerbares MIS-Bauelement nach Anspruch 1, dadurch gekennzeichnet (14, 20) daß der zweite Bereich (19) der Gate-Elektrode (16, 24) eine Unterbrechung aufweist oder dieser Bereich vollständig fehlt.

6. Steuerbares MIS-Bauelement nach Anspruch 5, dadurch gekennzeichnet, daß die Schicht (20) unterhalb der Unterbrechung der Gate-Elektrode ebenfalls eine Unterbrechung aufweist.

## Claims

1. A controllable MIS component having a semiconductor body (1) which has a plurality of source zones (4) electrically connected in parallel and which are embedded in a respective zone (3) of opposite conductivity type, channel zones (5) arranged at the surface of the semiconductor body and which form parts of said zones (3) of opposite conductivity type, a drain zone (2) which is common to all the source zones (4) and which appears at the surface of the semiconductor body (1) between said zones (3) of opposite conductivity type, a gate electrode (8, 16, 24) which is insulated from the semiconductor body (1) by an insulating layer (7) and which covers the channel zones (5), a part of each source zone (4) and at least a part of that part of the drain zone (2) which appears at the surface of the semiconductor body (1), and in which the gate electrode (8, 16, 24) has two regions (9, 10; 18, 19) of which the first region (9, 18) covers the channel zones (5) and is arranged at a first interval from the surface of the semiconductor body (1) and the second region (10, 19) is located between the channel zones (5) and is arranged at a second, larger distance from the surface of the semiconductor body (1), characterised in that in the drain zone (2), a layer (13, 14, 20) which has the same conductivity type as but a higher conductivity than the drain zone (2) is arranged at the surface of the semiconductor body (1).

2. A controllable MIS component as claimed in Claim 1, characterised in that the layer (14, 20) abuts against the channel zones (5).

3. A controllable MIS component as claimed in Claim 1, characterised in that an interspace (15) is present between the layer (14, 20) and the channel zones (5); and that the interspace is covered by the first region (9, 18) of the gate electrode (8).

4. A controllable MIS component as claimed in Claim 3, characterised in that the first region (9, 18) overlaps the layer (14, 20).

5. A controllable MIS component as claimed in Claim 1, characterised in that the second region (19) of the gate electrode (16, 24) is interrupted, or is entirely absent.

6. A controllable MIS component as claimed in Claim 5, characterised in that the layer (20) beneath the interruption in the gate electrode also contains an interruption.

## Revendications

1. Composant MIS pouvant être commandé, comportant un corps semiconducteur (1) qui possède une multiplicité de zones de source (4) branchées électriquement en parallèle et qui sont insérées dans le zones respectives (3) possédant le type de conductivité opposé, des zones de canal (5) qui sont situées au niveau de la surface du corps semiconducteur et qui font partie desdites zones (3) possédant le type de conductivité opposé, une zone de drain (2) commune à toutes les zones de source (4) et qui est située entre lesdites zones (3) possédant le type de conductivité opposé à la surface du corps semiconducteur (1), une électrode de grille (8, 16, 24), qui est isolée du corps semiconducteur (1) par une couche isolante (7) et qui recouvre les zones de canal (5), une partie de chaque zone de source (4) et au moins un élément de la partie de la zone de drain (2), qui est situé à la surface du corps semiconducteur (1), et dans lequel l'électrode de grille (8, 16, 24) comporte deux régions (9, 10; 18, 19) dont la première (9, 18) recouvre les zones de canal (5) et se trouve à une première distance de la surface du corps semiconducteur (1) et dont la seconde (10, 19) est située entre les zones de canal (5) et se situe à une seconde distance supérieure par rapport à la surface du corps semiconducteur (1), caractérisé par le fait que dans la zone de drain (2) se trouve disposée, à la surface du corps semiconducteur (1), une couche (13, 14, 20) qui possède le même type de conductivité, que la zone de drain (2), mais une conductivité supérieure à cette zone.

2. Composant MIS pouvant être commandé suivant la revendication 1, caractérisé par le fait que la couche (14, 20) est en aboutement contre les zones de canal (5).

3. Composant MIS pouvant être commandé selon la revendication 1, caractérisé par le fait qu'un espace intercalaire (15) est présent entre la couche (15, 20) et les zones de canal (5) et que l'espace intercalaire est recouvert par la première région (9, 18) de l'électrode de grille (8).

4. Composant MIS pouvant être commandé suivant la revendication 3, caractérisé par le fait que la première région (9, 18) recouvre la couche (14, 20).

5. Composant MIS pouvant être cormandé, suivant la revendication 1, caractérisé par le fait que la seconde région (19) de l'électrode de grille (16, 24) comporte une interruption ou que cette région est totalement absente.

6. Composant MIS pouvant être commandé suivant la revendication 5, caractérisé par le fait que la couche (20) comporte également une interruption au-dessous de l'interruption de l'électrode de grille.

# FIG 1

# FIG 2

# FIG 3

1

# FIG 4

# FIG 5